(19)

Europäisches Patentamt

European Patent Office

Office européen des brevets

(11) **EP 4 546 393 A1**

(12) **EUROPEAN PATENT APPLICATION**

(43) Date of publication:
**30.04.2025 Bulletin 2025/18**

(21) Application number: **23206125.9**

(22) Date of filing: **26.10.2023**

(51) International Patent Classification (IPC):
*H01J 37/22* (2006.01)   *H01J 37/244* (2006.01)
*H01J 37/28* (2006.01)

(52) Cooperative Patent Classification (CPC):
**H01J 37/28; H01J 37/222; H01J 37/244;**
H01J 2237/2448; H01J 2237/24495;
H01J 2237/24592

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventor: **WIELAND, Marco, Jan-Jaco**
**5500 AH Veldhoven (NL)**

(74) Representative: **ASML Netherlands B.V.**
**Corporate Intellectual Property**
**P.O. Box 324**
**5500 AH Veldhoven (NL)**

(54) **CHARGED PARTICLE-OPTICAL APPARATUS AND METHOD FOR DETECTING SIGNAL CHARGED PARTICLES**

(57)     The present disclosure relates to a charged particle-optical apparatus configured to direct charged particles toward a sample, the charged particle-optical apparatus comprising: a charged particle-optical device configured to direct a plurality of beams of charged particles along respective beam paths toward a sample; a support configured to support the sample and configured to position the sample relative to the beam paths; a detector array of detector elements configured to detect signal charged particles emitted from respective areas of a surface of the sample so as to generate respective detection signals; and a cross talk remover configured to correct the detection signals for cross talk by operating on the detection signals independently of position of the sample relative to the beam paths.

Fig. 2

EP 4 546 393 A1

**Description**

FIELD

The embodiments provided herein generally relate to apparatus for directing charged particles such as electrons towards a sample and related apparatus and methods.

BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incident particles or other processing steps such as etching, deposition or chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern assessment systems for example pattern inspection or metrology systems with a charged particle beam have been used to assess samples, for example to detect pattern defects. Such charged particle are typically electrons. These systems typically use electron microscopy techniques, such as a scanning electron microscope (SEM). In a SEM, an electron beam is directed to impact a sample. The electron beam may be focused as a spot on the sample. The interactions between the material structure of the sample and the electrons at the spot s cause electrons to be emitted from the surface which may be referred as signal electrons or more generally signal charged particles, and may include secondary electrons, backscattered electrons or Auger electrons.

By scanning the electron beam as a probing spot over a part of the sample surface, signal particles are emitted from the scanned surface. On detection of these signal electrons, an assessment system may generate a data set which may be rendered into an image that may represent characteristics of the material structure of the surface of the signal. In such assessment the signal particles are detected by a detector. An assessment system may scan a plurality of beams towards a sample surface. In such a system the detector may be an array of detector elements each corresponding to a different beam. The different beams may be assigned to different respective areas of the sample surface. Thus, different detector elements may detect signal particles from different areas of the sample surface. As the sample is scanned, the detector transmits detection signals comprising data for processing. The data processed to generate a data set, e.g. an image, comprising pixels. Different pixels correspond to respective detection signals each from a respective detector element for a respective portion (or area) of the sample surface.

This assumes that each detector only ever detects signal particles generated by impact of its corresponding beam on the sample, or more general signal particles from its respective portion of the sample surface. However, there is a risk of crosstalk; that is detection by detector element of signal particles from a portion of the sample surface assigned to a different detector element. Such crosstalk can reduce the detection accuracy and consequential quality of the data set and thus the image.

SUMMARY

It is an object of the present disclosure to reduce the undesirable influence of cross talk on the assessment of a sample.

According to an aspect of the invention, there is provided a charged particle-optical apparatus configured to direct charged particles toward a sample, the charged particle-optical apparatus comprising:

a charged particle-optical device configured to direct a plurality of beams of charged particles along respective beam paths toward a sample;
a support configured to support the sample and configured to position the sample relative to the beam paths;
a detector array of detector elements configured to detect signal charged particles emitted from respective areas of a surface of the sample so as to generate respective detection signals; and
a cross talk remover configured to correct the detection signals for cross talk by operating on the detection signals independently of position of the sample relative to the beam paths.

According to an aspect of the invention, there is provided a method for detecting backscattered charged particles, the method comprising:

directing a plurality of beams of charged particles along respective beam paths toward a sample;
supporting the sample and positioning the sample relative to the beam paths;

detecting signal charged particles emitted from respective areas of a surface of the sample with respective detector elements of a detector array so as to generate respective detection signals; and

correcting the detection signals for cross talk by operating on the detection signals independently of position of the sample relative to the beam paths.

Advantages of the present invention will become apparent from the following description taken in conjunction with the accompanying drawings wherein are set forth, by way of illustration and example, certain embodiments of the present invention.

## BRIEF DESCRIPTION OF FIGURES

The above and other aspects of the present disclosure will become more apparent from the description of exemplary embodiments, taken in conjunction with the accompanying drawings.

FIG. 1 is a schematic diagram illustrating an exemplary assessment apparatus.

FIG. 2 is a schematic diagram illustrating an exemplary charged particle-optical apparatus that is part of the assessment apparatus of FIG. 1.

FIG. 3 is a schematic diagram illustrating a charged particle-optical device that is part of the charged particle-optical apparatus of FIG. 2.

FIG. 4 is a schematic diagram illustrating a charged particle-optical device that is part of the charged particle-optical apparatus of FIG. 2.

FIG. 5 is a schematic diagram of the charged particle-optical device shown in FIG. 2.

FIG. 6 is a schematic diagram of the detector array shown in FIG. 2.

FIG. 7 is a schematic diagram of part of the detector array shown in FIG. 2.

FIG. 8 is a graph showing the relationship between the angle at which backscattered electrons are emitted from a sample and the number of backscattered electrons.

FIG. 9 is a graph showing the relationship between the percentage of the percentage of signal charged particles that are detected by neighbouring detector elements and the signal to noise ratio (SNR) as a percentage of the SNR where cross talk is absent.

FIG. 10 is a graph showing the relationship between the distance from the sample to the detector array and the detection efficiency when cross talk is not removed.

FIG. 11 is a graph showing the relationship between the distance from the sample to the detector array and detection efficiency when the cross talk is removed.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

## DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by assessment systems (such as a SEM) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal charged particles e.g. secondary electrons and/or backscattered electrons. Secondary electrons may be considered to have an energy of up to 50eV. Backscattered electrons, although having an energy spectrum from substantially zero to the energy of the maximum of the charged particle-optical device, are conventionally set to electrons (or signal electrons) having an energy exceeding 50eV. The detection apparatus captures the signal charged particles (e.g. secondary electrons and/or backscattered electrons) from the target as the target is scanned so that the scanning electron microscope may create an image of the scanned area of the target. A design of charged particle-optical apparatus embodying these scanning electron microscope features may have a single beam. For higher throughput such as for assessment, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam assessment apparatus may therefore assess a target much quicker, e.g. by moving the target at a higher speed, than a single-beam assessment apparatus.

An implementation of a known multi-beam assessment apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

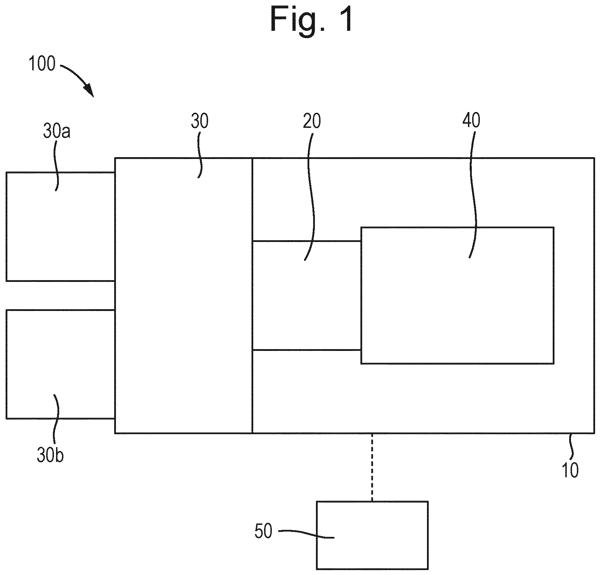

Reference is now made to **FIG. 1,** which is a schematic diagram illustrating an exemplary assessment apparatus 100. The assessment apparatus 100 of **FIG. 1** includes a vacuum chamber 10, a load lock chamber 20, an electron-optical apparatus, an equipment front end module (EFEM) 30 and a controller 50. The electron-optical apparatus 40 may be within the vacuum chamber 10. The electron-optical apparatus may comprise an electron-optical apparatus 40 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be assessed (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the electron-optical apparatus 40 by which it may be assessed. An electron-optical apparatus 40 may comprise either a single beam or a multi-beam electron-optical apparatus.

The controller 50 is electronically connected to the electron-optical apparatus 40. The controller 50 may be a processor (such as a computer) configured to control the electron beam assessment apparatus 100. The controller 50 may also include a processing circuitry configured to execute various signal and image processing functions. While the controller 50 is shown in FIG. 1 as being outside of the structure that includes the main chamber 10, the load lock chamber 20, and the EFEM 30, it is appreciated that the controller 50 may be part of the structure. The controller 50 may be located in one of the component elements of the electron beam assessment apparatus or it may be distributed over at least two of the component elements. While the present disclosure provides examples of main chamber 10 housing an electron beam assessment apparatus, it should be noted that aspects of the disclosure in their broadest sense are not limited to a chamber housing an electron-optical device. Rather, it is appreciated that the foregoing principles may also be applied to other apparatuses and other arrangements of apparatus that operate under the second pressure.

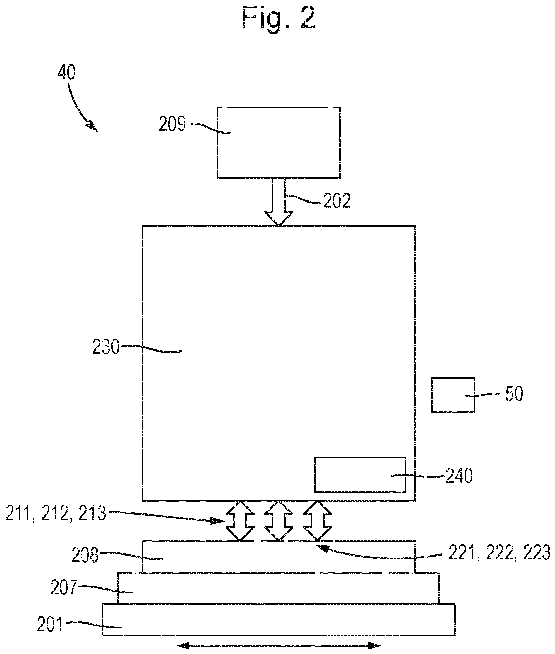

**FIG. 2** is a schematic diagram illustrating an exemplary electron-optical apparatus 40. The electron-optical apparatus 40 may be provided as part of the assessment apparatus 100 of **FIG. 1.** The electron-optical apparatus 40 includes a source 201, an electron-optical device 230 (which may also be referred to as an electron-optical column) and a support for supporting a sample. (In a different embodiment, the electron-optical device comprises the source 201).

The support may be a sample holder 207 that supports a sample 208. The sample may be at a sample position relative to the electron-optical device 230. The sample holder 207 supports the sample 208 for assessment. The sample holder 207 is supported by a stage such as an actuatable stage 209. The stage may actuate the sample relative to the electron-optical device 230. The stage may move the sample through the sample position relative to the electron-optical device 230.

The source 201 may comprise a cathode (not shown) and at least one of an extractor and anode (not shown). During operation, the source 201 is configured to emit electrons as a source beam. The cathode emits the electrons. The extractor and/or anode may extract or accelerate the electrons to form the source beam 202.

The electron-optical device 230 may be configured to generate a plurality of primary beams 211, 212, 213 (which may be referred to as sub-beams or beamlets) from the source beam 220. The electron-optical device 230 may be configured to direct the primary beams 211, 212, 213 along respective beam paths toward a sample location for the sample 208; collectively the beam paths may be referred to as a grid path. Although three beams are illustrated, the number of primary beams may be of the order of 100s or 1,000s, for example up to 20,000 per electron-optical apparatus 140. The plurality of primary beams may be referred to collectively as a multi-beam or a beam grid. The electron-optical device 230 has a field of view which may be defined as the area of the surface of the sample 208 at the sample position. Within the field of view the primary beams 211, 212, 213 can be scanned over a region of a sample surface. During such scanning parameters of the primary beams, e.g. aberrations of the beams, remain within a defined range of values/specification. Alternatively or additionally, the field of view may be defined by the maximum scan range of the electron-optical device 230 for a given location of the electron-optical device 230 relative to the sample 208. In an arrangement, the different primary beams may have an assigned beam area in the field of view that corresponds to the field of view of the corresponding beam. The scan range of a primary beam may be that of its beam area. The different beam areas may comprise the field of view at the sample position. An electron-optical device with a single source may have a field of view at the sample position of a size that is of an order of magnitude of millimeters, for example up to 5mm, 10mm 20mm.

The electron-optical device 230 comprises a plurality of electron-optical elements positioned along the grid path. The electron-optical elements are configured to operate on the different beams. For example, the electron-optical elements may be configured to focus, deflect or correct the beams. One more of the electron-optical elements may be substantially planar across the grid path. Such an electron-optical element may be a plate. The electron-optical elements may be arranged in at least one stack of electron-optical elements. Such a stack may comprise one more electron-optical elements as plates. Such an electron-optical element may be positioned upbeam or downbeam with respect to another of the electron-optical elements. The terms upbeam and downbeam relate to the direction of the beams from the source 201 to the sample 208 during use of the electron-optical device 230. An electric power source 290 may be provided to apply respective potentials to electrodes of the electron-optical device 230. When such a power device is non-operational, upbeam and downbeam may refer to the geometrical features in the different elements providing a path between the source and the end of the device that in use faces a sample. Features closer to the source are referred to as 'upbeam' of features further away from the source; and vice-versa for downbeam.

The electron-optical device 230 may form three probe spots 281, 282, 283 on the surface of the sample 208. The electron-optical apparatus may be controlled to scan the beams over a sample surface so as to scan the probe spots 281, 282, 283 across respective scanning portions of the sample 208. In such scanning the stage may be controlled to move simultaneously with the operation of the electron-optical device 230 to deflect the primary beams 211, 212, 213. Different modes of scanning may be available which may in part depend on the design of the electron-optical device 230. In response to incidence of the primary beams 221, 222, 223 on the sample 208, signal electrons come from the sample 208 which may include secondary electrons and backscattered electrons. Secondary electrons typically have electron energy of at most 50 eV. Backscattered electrons typically have electron energy of more than 50 eV and less than the landing energy of the primary beams 211, 212, 213.

The electron-optical device 230 may comprise an objective lens array and a control lens array. The control lens array may be considered to be part of the objective lens array because the control lens array bestows additional degrees of freedom to the objective lens array. The objective lens array and control lens array may take the form of aperture arrays for example as series of plates in which respective apertures are defied for passage of the primary beams. The objective lens array configured to focus the primary beams 211, 212, 213 onto the sample 208. The control lens array may be controlled to adjust the landing energy and/or magnification of the primary beams. Such control may be achieved without adjusting the focus of the settings of the objective lens array. The electron-optical apparatus 140 further comprises a detector array 240. The detector array 240 may be part of the electron-optical device 230 for example integrated into the objective lens array. The detector array 240 detects signal electrons from the sample 208. The detector array 240 generates detection signals based on detection of the signal electrons.

The detector array 240 may provide the surface of the electron-optical apparatus 140 facing the sample 208, e.g. the bottom surface of the electron-optical device 230. That is the detector array 240 may therefore provide the sample a facing surface of the electron-optical device 230. There may be more than one detector array at different positions along the paths of the beams 211, 212, 213. Alternatively, the detector array 240 may be located away from the path of the primary beams of the electron-optical device 230. For example, the electron-optical apparatus 140 may comprise a secondary electron-optical device that branches off from the electron optical device. The electron-optical device may be configured to direct secondary electrons to the detector array 240 via the secondary electron-optical device.

The detector array 240 may comprise a plurality of detector elements, with at least one detector element per beam. The detector array 240 may comprise a plurality of detector elements corresponding to respective portions of the sample surface. The detector elements may comprise at least one of: charge capture electrodes, detection diodes, and a scintillator. Such a charge capture electrode detects at least some of the signal electrons, for example as charge, which over time is current. Such a detection diode may be a PIN diode and detects at least some of the signal electrons for example in a semiconductor substrate. A scintillator comprises a scintillator material (such as YAG) that converts signal electrons into photons that are detected with an optical detector. The optical detector may be considered to be part of the detector element. In an arrangement in which the detector is in a detector within the electron-optical device, the detector elements may be adjacent apertures in a plate towards the bottom surface of the electron-optical device 230. The plate of the detector array may be positioned above the objective lens, in the bottom of the objective lens device or an intermediate location that is desirable field free. The detector elements may surround the apertures 266 in the plate. The apertures in the plate of the detector array allow passage of the primary beams 211, 212, 213 to pass towards the sample 208. Each detector element may comprise a plurality of detection segments or may constitute a single sensitive surface for each beam. The detector elements generate a detection signal on detection of a signal electron. The detection signal may be transmitted to a processor to derive a data set for a portion of the sample surface, e.g. as a pixel. For example, the detection signal may represent a grey value or an intensity value of a pixel of the data set, e.g. as an image.

The detector array 240 may send the detection signals, which may be partially processed, to the controller 50 or to a signal processing system 280 which may be part of the controller 50 or may be remote from the charged particle apparatus for in a computer rack remote from the apparatus, the assessment apparatus may be part of an assessment system that comprises the computer rack. The controller 50 or the signal processing system 280 may be configured to process the data sets for assessment of the sample, such as defect inspection. Such processed data may be rendered as an image.

The controller 50 (for example a control system comprising distributed controllers) may be connected to various parts of the electron-optical apparatus 40 of **FIG. 2,** desirably all the different parts of the electron-optical apparatus, such as the source 201, the detector array 240, the electron-optical device 230, and the actuatable stage 209. The controller 50 may perform various assessment operations on the data set, such as image processing functions, and signal processing functions. The controller 50 may also generate various control signals to govern operations of the assessment apparatus 100.

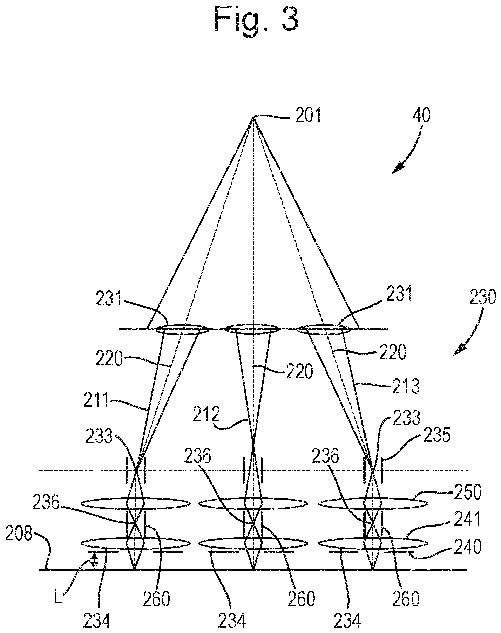

**FIG. 3** schematically depicts an electron-optical apparatus 40 of an assessment apparatus, e.g. the assessment apparatus 100 of **FIG. 1.** The electron-optical apparatus 40 of **FIG. 3** may be the electron-optical apparatus 40 of **FIG. 2** in which the electron-optical elements of the electron-optical device 230 comprise a condenser lens array 231, a collimator array 235, a control lens array 250, an objective lens array 241 a scan deflector array 260, and a detector array 240, for example as described herein above.

The source 201 generates a diverging source beam. The condenser lens array 231 defines a plurality of beams 211, 212, 213 from the source beam. The condenser lens array 231 focuses the primary beams 211, 212, 213 at respective intermediate foci 233. The condenser lens array 231 may be electrostatic. In an alternative embodiment the condenser lens array 231 comprises a magnetic element.

The beam paths 220 diverge downbeam of the condenser lens array 231. In an embodiment, a collimator array 235 such as a deflector array is at the intermediate focuses. The collimator array is positioned in the sub-beam paths at, or at least around, the position of the corresponding intermediate focusses 233 or focus points (i.e. points of focus). The collimators are positioned in or close to the beam paths at the intermediate image plane of the associated beam. The collimators 235, e.g. deflectors, are configured to operate on the respective primary beams 211, 212, 213. The collimators 235 are configured to bend a respective primary beam 211, 212, 213 by an amount effective to ensure that the beam path of the respective primary beams are incident on the sample 208 substantially normally (i.e. at substantially 90° to the nominal surface of the sample). The collimators 235 in effect collimate the paths of the primary beams so that before the collimators, the paths of the primary beams with respect to each other are diverging. Downbeam of the collimators the beam paths of the primary beams are substantially parallel with respect to each other, i.e. substantially collimated. Suitable collimators are deflectors disclosed in WO2021156121A1 filed on 7 February 2020 which is hereby incorporated by reference with respect to the application of the deflectors to a multi-beam array. The collimator may comprise a macro collimator, instead of, or in addition to the deflectors 235.

The deflectors of the scan deflector array 260 may be formed at apertures of the scan deflector array 260. The deflectors may comprise respective sets of individually controllable electrodes. Such a deflector may be referred to as a multipole deflector. The individually controllable electrodes extend partially along the beam path of the respective beam. The individually controllable electrodes may be controlled to generate, in use, a scan movement of the respective beam across the sample 208. Typically, the sets of individually controllable electrodes operate for example with simultaneous stage movement, to scan all of the beams 211, 212, 213 simultaneously parallel across the individual fields of view of the respective objective lenses of the objective lens array 241. Alternatively, the deflector array 260 may comprise strip deflectors configured to deflect a row of beams along the individual fields of view of the respective objective lenses of the objective lens array 241.

The objective lens array 241 is configured to focus the beams 211, 212, 213 onto the sample 208. The objective lens array 241 may comprise a stack of plates. Different potentials are applied to respective plates so as to generate electrostatic fields between adjacent plates. The electrostatic fields generate electrostatic lenses that may be configured to focus the beams 211, 212, 213. The objective lens array 241 may be proximate the sample 208. In an embodiment the objective lens array may provide a facing surface of the electron-optical device proximate to the sample, for example the sample surface. The facing surface may face the sample surface.

The control lens array 250 may be upbeam of the objective lens array 241. The control lens array 250 may comprise a stack of plates, for example at least three plates. The control lens array 250 may be configured to control electron-optical parameters of the primary beams 211, 212, 213. In an embodiment, the most downbeam plate of the control lens array 250 is the most upbeam plate of the objective lens array 241. Alternatively, the control lens array 250 may be considered to be part of the objective lens array 241.

In an arrangement, the electron-optical device 230 is arranged to detect signal electrons that are backscattered electrons; that is the signal electrons that reach the detector array are filtered to remove secondary electrons. In such an arrangement the primary electrons are accelerated by the objective lens array 241 towards the sample 208. Accelerating the primary electrons increases their energy. It enables backscattered electrons to have a larger energy range than if the primary electrons are decelerated by the objection lens before reaching the sample 208. A repulsive field may be applied between the sample surface and the electron-optical device 230, or at least the surface of the electron-optical device facing the sample such as a surface of the detector array.

The intermediate focusses 236 (interchangeably referred to as the intermediate foci) between respective control lenses and corresponding objective lenses may be in a common plane as depicted in **FIG. 3.** Thus, the intermediate focusses 236 may be positioned in a plane, and specifically, a plane between the control lens array and the objective lens array. The plane of the intermediate foci may be positioned in a plane which is parallel to the control lens array and/or the objective lens array. The intermediate focusses 236 may be in an array of intermediate foci. The intermediate focus may be a consequence of potentials applied to the electrodes of the control lens array being set so as to decelerate the primary beams. The objective lens array may accelerate the decelerated primary beams towards the sample. The electrons in the accelerated primary beams may have high energy enabling backscatter electrons to be generated from the sample having a larger energy range and/or from within the sample below the sample surface.

In an embodiment the detector array 240 may be integrated into the objective lens array 241. Alternatively (or additionally) the detector array 240 may be upbeam of the bottom surface of the electron-optical device 230. For example, the detector array 240 may be in or upbeam of the objective lens array 241. The detector array 240 is configured to be positionable proximate to the sample 208, and may have a distance L between the sample 208 and the detector array 240. A potential applied to the detector relative to the sample may serve to cause a repulsive electrical filed or repulsion field. The repulsion field may repel secondary electrons away from the detector array. The repulsion field may filter out from reaching the detector array secondary electrons from the signal electrons that are generated by the sample.

In a different arrangement without a repulsion field and with the objective lens set to operate as a decelerating lens, the detector array may detect signal electrons including backscattered electrons and secondary electrons. The potentials applied to the control lens may operate on the primary beams to focus the primary beams towards a focus position down beam of the objective lens array, so that the primary beams do not have a cross-over between the control lens array and the objective lens array.

The electron-optical device 230 may comprise one or more corrector arrays configured to at least partly correct one or more types of aberration of the beams. Such corrector arrays may be associated with or integrated into the control lens array 250 and/or the objective lens array 241.

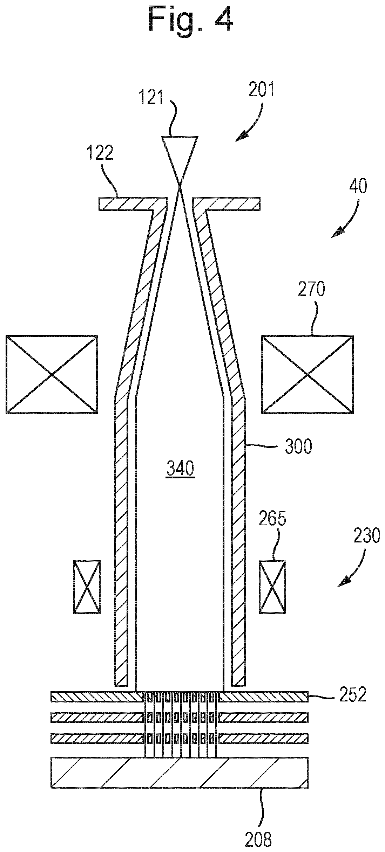

As shown in **FIG. 4,** in an embodiment the electron-optical apparatus 40 comprises a beam tube 300 (which may also be called a tube, liner tube, or booster tube). In an embodiment the beam tube 300 is arranged to surround the multi-beam path. The beam tube 300 surrounds the paths of electrons. The electrons may be a source beam emitted from the source 201 towards a sample. The electrons may be of a plurality of beams of the multi-beam. The beam tube 300 may surround the source beam path or the multi-beam path for example when viewed along the primary axis of the electron-optical apparatus 40, i.e. in the direction of the electron beam. In an embodiment the beam tube 300 is configured to surround only part of the electron path, i.e. part of the electron path along the length of the electron path for example a length along part of the electron path. For example, as shown in **FIG. 4,** in an embodiment the beam tube 300 surrounds the part of the multi-beam path from the source 201 to just above a beam forming array 252 configured to define beams from a primary beam. In other embodiments, the beam tube 300 surrounds different portions, e.g. lengths, of the multi-beam path.

In an embodiment the beam tube 300 is configured to operate at a first potential difference from ground. A sample support may be configured to support the sample 208 at a second potential difference from ground or at ground. The first potential difference may be greater than the second potential difference and such as to accelerate the electrons of the multi-beam towards the sample 208. Arranging for the potential difference between the sample and the immediate environment to be relatively low may reduce the possibility of electrical breakdown in the vicinity of the sample 208. This can reduce the possibility of the sample 208 being damaged. The risk of damage to components of the electron-optical device 230 such as the detector array 240 (which may feature delicate electronic elements) may be reduced.

As explained above and exemplified in **FIG. 4,** the electron source 201 may comprise a cathode 121 and an anode 122 (which may also be called an extractor or an extractor electrode). See EP3971940A1 and EP3971939A1, hereby incorporated by reference at least so far as designs comprising an electron source comprising a cathode and an anode. The cathode 121 and the anode 122 are configured to operate with a potential difference between them. The cathode 121 is configured to emit the electron beam. The anode 122 is configured to accelerate the electron beam towards the sample 208. Note, this source arrangement is a simplified arrangement. The source 201 may have a different arrangement and other electrodes, so long as the source 201 has a most downbeam source electrode, which is here referred to as the anode 122.

As shown in **FIG. 4,** in an embodiment the beam tube 300 is electrically connected to the anode 122. By electrically connecting the beam tube 300 to the anode 122, there is no electric field formed between the source 201 and the beam tube 300. Any unwanted lensing effect upbeam of the beam tube 300 is avoided. The beam tube 300 may be formed together with the anode 122. The beam tube 300 and the anode 122 may be integral. Alternatively, the beam tube 300 may be separated from the source 201. The beam tube 300 may be distanced along the axial direction from the anode 122.

As shown in **FIG. 4,** in an embodiment at least part of the electron-optical device 230 is downbeam of the most downbeam end of the beam tube 300. For example, the beam forming array 252, the control lens array 250 and the objective lens array 241 may be provided downbeam of the beam tube 300. In an embodiment, the part of the electron-optical device 230 downbeam from the beam tube 300 may be configured to decelerate the electron beam.

In an embodiment, the electron-optical apparatus 40 is configured such that the electron beam passes through the electron-optical apparatus 40 without undesirable lensing effects being applied to the beam. The downbeam end of the beam tube 300 may be configured to be in a region that has a small electric field or no electric field. This can help reduce or avoid any lensing effect on the electron beam that could be caused by an electric field between the beam tube 300 and any parts of the electron device 41 downbeam of the beam tube 300. In a different arrangement, which may be less desirable, there may be a controlled potential difference between the downbeam end of the beam tube 300 and a surface of an adjacent part of the electron-optical device 230 for lensing the paths of the electrons towards the sample 208.

As shown in **FIG. 4,** in an embodiment the beam tube 300 is spaced apart from the part of the electron-optical device 230 downbeam of the beam tube 300. The separation may make it easier to manufacture the electron apparatus (by easing tolerances) and/or to replace part or all of the electron-optical device 230. In an embodiment the separation is at most 1mm. Any electric field between the beam tube 300 and any part of the electron-optical device 230 downbeam of the beam tube 300 may be confined to a small distance. This arrangement may help to reduce or even prevent the effect of any electric field between the beam tube 300 and a part of the electron device downbeam of the beam tube 300. In an alternative arrangement, the spacing apart of the beam tube 300 and a surface of the electron device 41 downbeam of the beam tube 300 may enable a lensing operation on the electrons projected towards a sample position.

In an alternative embodiment the beam tube 300 is electrically connected to the part of the electron-optical device 230 that is downbeam of the beam tube 300. For example, the beam tube 300 may be structurally connected to and/or integral with the associated plate, for example the beam forming array 252.

In the example of **FIG. 4,** a macro collimator 270 comprising a magnetic component is provided, for example as part the electron-optical device 230. The magnetic component can influence trajectories of electrons within the beam tube 300 while being located outside of the beam tube 300.

In an alternative embodiment the macro collimator 270 comprises an electrostatic component. Such an electrostatic component may be affected by the beam tube 300, for example its shielding of electrostatic fields external to the beam tube 300. In an embodiment the electrostatic component of the macro collimator 270 is located within the beam tube 300 (not shown) or between lengths or sections of the beam tube (see EP Application 21199203.7 filed 27 September 2021, hereby incorporated by reference at least so far as designs comprising electron-optical elements and a beam tube and its sections).

In an embodiment the electron-optical device 230 comprises a macro scan deflector 265. The macro scan deflector 265 is configured to deflect respective portions of the electron beam. The respective portions correspond to different sub-beams further downbeam. Deflection of the portions by the macro scan deflector 265 thus causes deflection of the respective sub-beams of electrons, in the multi-beam, to be scanned relative to, for example over, the sample 208. As shown in **FIG. 4** in an embodiment the macro scan deflector 265 is upbeam of the downbeam end of the beam tube 300.

As shown in **FIG. 4,** in an embodiment the macro scan deflector 265 comprises a magnetic deflector. The macro scan deflector 265 may be located outside of the beam tube 300.

In an alternative embodiment the macro-scan deflector is electrostatic. Such an electrostatic scan deflector may be placed between sections or lengths of the beam tube 300. The electrostatic scan deflector may be spaced away from the sections of the beam tube 300 upbeam and downbeam of the scan deflector 300.

Additionally or alternatively a scan deflector comprising an array of deflectors may be provided instead of a macro scan deflector. Such an array of deflectors is provided within the electron-optical device 230 as scan deflector array 260 as depicted in **FIG. 3.** Such an array of scan deflectors may be associated with an objective lens array, for example in which a deflector of the array is associated with each beam of the multi-beam.

In the embodiment shown in **FIG. 4,** the beam tube 300 extends continuously from a position close to the beam forming array 252 to the source 201. When the beam tube 300 is metallic (or is coated with a metallic material) this will shield the interior of the beam tube 300 from electrostatic fields generated outside of the beam tube 300. As explained above, elements may be provided for manipulating electron trajectories within the beam tube 300 either via magnetic fields generated outside of the beam tube 300 or via magnetic or electrostatic fields generated within the beam tube 300. A further possibility, not shown, is to provide gaps in the beam tube 300 to allow electric fields generated outside of the beam tube to influence electron trajectories within the beam tube 300.

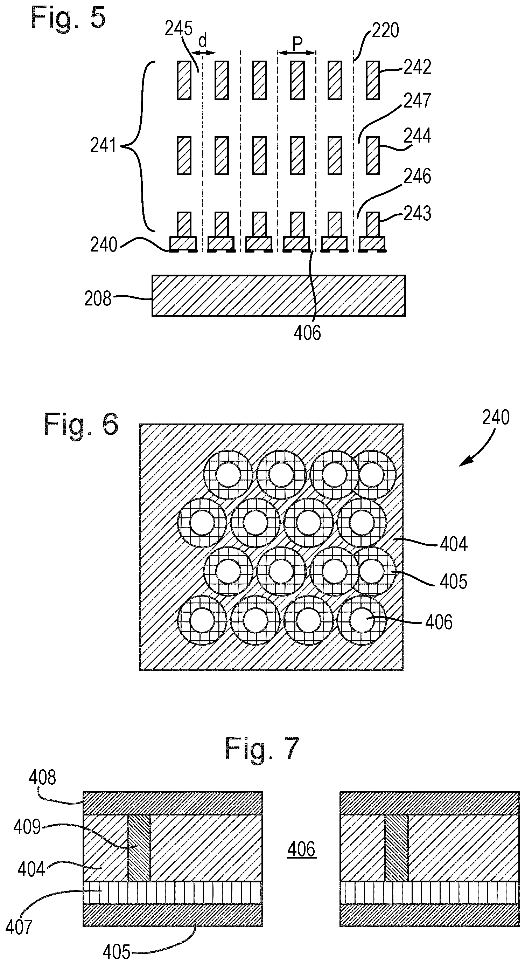

The objective lens array 241 may comprise at least two electrodes in which are defined aperture arrays. In other words, the objective lens array comprises at least two electrodes with a plurality of holes or apertures. **FIG. 5** show electrodes 242, 243, 244 which are part of an exemplary objective lens array 241 having respective aperture arrays 245, 246, 247. The position of each aperture in an electrode corresponds to the position of a corresponding aperture in another electrode. The corresponding apertures operate in use on the same beam, sub-beam or group of beams in the multi-beam. In other words, corresponding apertures in the at least two electrodes are aligned with and arranged along a sub-beam path, i.e. one of the beam paths 220. Thus, the electrodes are each provided with apertures through which the respective sub-beam 211, 212, 213 propagates.

The objective lens array 241 may comprise two or three electrodes, or may have more electrodes (not shown). An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. A benefit of two electrode lens over an Einzel lens is that the energy of an in-coming beam is not necessarily the same as an out-going beam. Beneficially the potential differences on such a two electrode lens array enables it to function as either an accelerating or a decelerating lens array.

Adjacent electrodes of the objective lens array 241 are spaced apart from each other along the sub-beam paths. The distance between adjacent electrodes, in which an insulating structure might be positioned as described below, is larger than the objective lens.

Desirably each of the electrodes provided in the objective lens array 241 is a plate. The electrode may otherwise be described as a flat sheet. Preferably, each of the electrodes is planar. In other words, each of the electrodes will preferably be provided as a thin, flat plate, in the form of a plane. Of course, the electrodes are not required to be planar. For example, the electrode may bow due to the force due to the high electrostatic field. It is preferable to provide a planar electrode because this makes manufacturing of the electrodes easier as known fabrication methods can be used. Planar electrodes may also be preferable as they may provide more accurate alignment of apertures between different electrodes.

The objective lens array 241 can be configured to demagnify the charged particle beam by a factor greater than 10, desirably in the range of 50 to 100 or more.

**FIG. 6** is a bottom view of the detector array 240 which comprises a substrate 404 on which are provided a plurality of detector elements 405 (which may be referred to as detection electrodes) each surrounding a beam aperture (or aperture) 406. The beam apertures 406 may be formed by etching through the substrate 404. In the arrangement shown in **FIG. 6,** the beam apertures 406 are shown in a hexagonal close packed array. The beam apertures 406 can also be differently arranged, e.g. in a rectangular array. The beam arrangement of a hexagonal arrangement may be more densely packed than a rectangular beam arrangement.

**FIG. 7** depicts at a larger scale a part of the detector array 240 in cross section. The detector elements 405 form the bottommost, i.e. most close to the sample 208, surface of the detector array 240. Between the detector elements 405 and the main body of the substrate 404 a logic layer 407 may be provided. At least part of the signal processing system 280 may be incorporated into the logic layer 407.

A wiring layer 408 is provided on the backside of, or within, the substrate 404 and connected to the logic layer 407 by through-substrate vias 409. The number of through-substrate vias 409 need not be the same as the number of beam apertures 406. In particular if the electrode signals are digitized in the logic layer 407 only a small number of through-silicon vias may be required to provide a data bus. The wiring layer 408 can include control lines, data lines and power lines. It will be noted that in spite of the beam apertures 406 there is ample space for all necessary connections. The detection module 402 can also be fabricated using bipolar or other manufacturing techniques. A printed circuit board and/or other semiconductor chips may be provided on the backside of detector array 240.

The integrated detector array described above is particularly advantageous when used with a tool having tunable landing energy as secondary electron capture can be optimized for a range of landing energies.

The detector array 240 may be implemented by integrating a CMOS chip detector into a bottom electrode of the objective lens array. Integration of a detector array 240 into the objective lens array 241 or other component of the charged particle-optical device allows for the detection of charged particles emitted in relation to multiple respective sub-beams. The CMOS chip is preferably orientated to face the sample (because of the small distance (e.g. 200 μm or less, 100 μm or less 50 μm or less, 40 μm or less, 30 μm or less, 20 μm or less, or 10 μm) between the sample and a bottom of the charged particle-optical device and/or electron-optical system). The detector array 240 may be proximate the sample. In an embodiment, detector elements 405 to capture the secondary charged particles are formed in the surface metal layer of the CMOS device. The detector elements 405 can be formed in other layers. Power and control signals of the CMOS may be connected to the CMOS by through-silicon vias. For robustness, preferably a passive silicon substrate with holes shields the CMOS chip from high E-fields.

In an embodiment the controller 50 is configured to process the detection signals within the CMOS chip.

In an embodiment, the electron-optical device 230 is configured to direct a plurality of beams 211, 212, 213 of electrons along respective beam paths towards the sample 208. The support (e.g. sample holder 207) is configured to support the sample 208. The sample 208 may be located at a sample location.

In an embodiment the support is configured to position the sample 208 relative to the beam paths. For example, in an embodiment, the electron-optical apparatus 40 comprises an actuatable stage 209. The actuatable stage 209 may be configured to position the sample 208 relative to the beam paths. For example, the actuatable stage 209 may move the sample 208 relative to the beam paths, e.g. relative to the electron-optical device 230. In an embodiment, the controller 50 is configured to control movement of the actuatable stage 209 so as to control the position of the sample 208 relative to the beam paths. In an alternative embodiment, the controller 50 may be configured to control movement of the electron-optical device 40 relative to the sample 208.

The electron-optical apparatus 40 comprises a detector array 240. The detector array 240 comprises a plurality of detector elements 405. In an embodiment the electron-optical device 230 comprises the detector array 240, as shown in **FIG. 2,** for example. Alternatively, the detector array 240 may be provided separate from the electron-optical device 230.

The detector elements 405 of the detector array 240 are configured to detect signal electrons emitted from respective portions of a surface of the sample 208. The detector elements 405 are configured to generate detection signals for the respective portions of the surface of the sample 208. The detection signals are based on the detected signal electrons. For example, a detection signal may be indicative of a number of signal electrons detected by a corresponding detector element 405.

Each of the portions of the surface of the sample 208 may be associated with a respective primary beam 211, 212, 213. A primary beam may be directed by the electron-optical device 230 onto a portion of the surface of the sample. Interaction between the beam and the sample 208 results in signal electrons being emitted from the portion. The signal electrons are intended to be detected by the detector element 405 that corresponds to that portion and to that beam. However, some of the signal electrons may be detected by other detector elements 405. This may be referred to as cross talk.

The detection signals comprise a proportion resulting from the detector element 405 detecting signal electrons emitted from the portion of the sample assigned to the detector element. Such a position may be a portion of the sample surface being scanned by the beam correspond to the detector element 405. The beam may be described as scanning the portion, for example for a period of time such as while the beams of the beam grid are scanning a region of the sample surface for example within the field of view of the beam grid. The portion may be described as the beam area or field of view beam of the beam within the beam grid. Every beam of the beam grid may be assigned such a beam area. A proportion of the detection signal detected by the detection element 405 may result from detection by the detection element 405 of signal electrons emitted from the sample from a different primary beam of the beam grid. This proportion of the detection signal may result from the detector element detecting signal electrons emitted from portions of the sample surface other than its respective portion. This may be referred to as a cross talk proportion.

In an embodiment, the detector element (or first detector element) is part of a detector array comprising other detector elements. The other detector elements that detect signal electrons from the portion assigned to the first detector element, may be referred to as neighbouring detector elements. That is the detector elements corresponding to the other portions from which signal electrons may be detected comprise neighbouring detector elements 405 of a respective detector element 405. As can be seen from **FIG. 6,** each detector element 405 has neighbouring detector elements 405. **FIG. 6** shows detector elements 405 arranged in a hexagonal array. In the arrangement shown in **FIG. 6,** the detector elements 405 generally have six nearest neighbours, i.e., six first order neighbouring detector elements 405. Another arrangement has the detector elements arranged in a rectangular array in which a detector element may have four nearest neighbours, i.e. four first order neighbouring detector elements 405. The nearest neighbours form a ring around the detector element 405. The detector elements 405 may detect signal electrons emitted from first order neighbouring portions of the portion to which the detector element 405 corresponds. An embodiment of the invention is expected to compensate for such cross talk.

In an embodiment, the cross talk not only from nearest neighbours but also from second, third and/or fourth order neighbours may be taken into account. The neighbouring detector elements may comprise second order neighbouring detector elements, third order neighbouring detector elements and/or fourth order neighbouring detector elements, for example. Second order neighbouring detector elements 405 are the detector elements 405 that neighbour the first order detector elements 405. The second order neighbouring detector elements form a second ring around the first order neighbouring detector elements 405. In the hexagonal array arrangement of **FIG. 6,** a detector element 405 may generally have twelve second order neighbouring detector elements 405. In the hexagonal arrangement, the detector elements 405 may each have 18 third order neighbouring elements. The order of neighbours taken into account may be selected and higher order neighbours may be considered. The number of neighbouring detector elements of each order considered is dependent on the geometrical arrangement of the detector elements in the detector array, e.g. a rectangular arrangement.

In an embodiment, the electron-optical apparatus 40 comprises a cross talk remover. The cross talk remover may be referred to as an inverter or a deconvolver. The cross talk remover is configured to correct the detection signals for cross talk. In an embodiment, the cross talk remover is configured to correct the detection signals for the cross talk by operating on the detection signals. In an embodiment, the cross talk remover is configured to operate on the detection signals independently of position of the sample 208 relative to the beam paths. An embodiment of the invention is expected to reduce cross talk more efficiently, for example, using less computational power, compared to removing cross talk in a way that depends on the position of the sample 208 relative to the beam paths. The cross talk remover may perform the same operation on each of the different detection signals. The operation may be time independent. Being time independent means that the scan position of each beam at a point in time is not necessarily a value required by the operation. By performing the same operation on the detection signals regardless of the scan position, fewer calculations are required in order to reduce the cross talk in the detection signals. An embodiment of the invention is expected to remove cross talk more accurately. By avoiding dynamically determining how to remove cross talk depending on the scan position, inaccuracies that result from such dynamic calculations may be reduced or avoided.

The cross talk remover may be implemented as software and/or as hardware. For example, in an embodiment the controller 50 comprises the cross talk remover. The controller 50 may comprise cross talk remover software configured to correct the detection signals for cross talk. The cross talk remover may be configured to process the detection signals that are output by the detector array 240.

For example, in an embodiment the cross talk remover is configured to correct the detection signals for respective pixels of an image of the sample 208. The detection signals from respective detector element 405 may correspond to respective pixels of an image of the sample 208 that may be formed. Such a pixel may be a data set for example for a beam. The image may be generated. Alternatively, the pixels may be determined without requiring the image to be generated. The detection signals may correspond to grey values for the pixels. In an embodiment, the cross talk remover is configured to remove cross talk from the pixels. The cross talk remover may correct the pixels for cross talk by operating on the pixels.

In an embodiment the cross talk remover is implemented at least partially as hardware. For example, in an embodiment the electron-optical apparatus 40 comprises electronics configured to correct the detection signals for cross talk. For example, in an embodiment the CMOS chip comprises the cross talk remover. Alternatively, the hardware for implementing the cross talk remover may be provided differently from a CMOS chip. Further the hardware may comprise a CMOS chip and at least another, different electronic component.

In an embodiment, the cross talk remover is configured to remove cross talk in the data path. The data path is the path of the detection signal data from detection by the detector array 240 to assessment of the sample 208.

In an embodiment, the detector array 240 is proximate the sample 208. The detector array may provide a proximate surface of the electron-optical device proximate to the sample, for example the sample surface. The proximate surface may face the sample surface. By reducing the distance between the detector array 240 and the sample 208, cross talk may be reduced. The cross talk proportion of the detection signals may be reduced. By providing the detector array 240 in close proximity to the sample 208, the detection efficiency may be improved. The detection efficiency relates to the proportion of signal electrons emitted from the sample surface that are detected by the detector array 240. The detection efficiency may be per beam. The detection efficiency may be the fraction of signal electrons that is detected by the detector element 405 (of its own portion). When the distance is too low the detection efficiency becomes small because many signal electrons pass through the aperture 406 that is there for the primary beam.

As shown in **FIG. 2** and **FIG. 3,** for example, in an embodiment, the detector array 240 is positioned to face the sample 240. The detector array 240 may form the most downbeam surface of the electron-optical device 230. The distance that signal electrons emitted from the sample 208 travel before being detected by the detector array 240 is desirably small. In an embodiment, the detector array 240 provides an end surface of the electron-optical device 230.

In an embodiment, the distance between the detector array 240 and the sample 208 is small relative to a pitch between the beam paths in a direction across the beam paths. In an embodiment the pitch between the beam paths corresponds to the pitch between detector elements 405 of the detector array 240. For example, the pitch may be between common features or the same feature of the detector elements. For example, the pitch may be the distance between a feature of the apertures of the detector elements across the detector array, or at least of neighbouring detector elements. For example, the pitch may be the distance between the centres of apertures 406 corresponding to adjacent detector elements 405, such as the first detector element and its neighbouring detector elements 405. By reducing the distance between the detector array 240 and the sample 208 relative the pitch between the beam paths, the cross talk may be reduced and/or the detection efficiency may be increased. Similarly, by increasing the pitch between the beam paths relative to the distance between the detector array 240 and the sample 208, the cross talk may be reduced and/or the detection efficiency per beam may be increased. That is, the proportion of a detection signal from a detector element derived from beams associated with neighbouring detectors may be reduced. In view of the proximate position of the detector elements 405 and the sample 208, the pitch may relate to the distance between neighbouring, such as adjoining, beam areas or portions such as of the sample surface. The pitch may substantially be the distance between common positions in neighbouring portions.

In an embodiment, the distance between the detector array 240 and the sample 208 in a direction along the beam paths is at most 100%, optionally at most 50%, optionally at most 20%, optionally at most 10% and optionally at most 5% of the pitch between the beam paths in the direction across the beam paths. In an embodiment, the distance between the detector array 240 and the sample 208 in a direction along the beam paths is at most 500 $\mu$m, at most 200 $\mu$m, optionally at most 100 $\mu$m, optionally at most 50 $\mu$m, optionally at most 20 $\mu$m and optionally at most 10 $\mu$m. In an embodiment, the distance between the detector array 240 and the sample 208 in a direction along the beam paths is at least 10 $\mu$m, optionally at least 20 $\mu$m, optionally at least 50 $\mu$m, optionally at least 100 $\mu$m and optionally least 200 $\mu$m.

In an embodiment, the pitch between the beam paths in a direction across the beam paths is at least 50 $\mu$m, optionally at least 100 $\mu$m and optionally at least 200 $\mu$m. In an embodiment, the pitch between the beam paths in a direction across the beam paths is at most 500 $\mu$m, optionally at most 200 $\mu$m, and optionally at most 100 $\mu$m.

In an embodiment, the distance between the detector array 240 and the sample 208 in a direction along the beam paths is at least 2%, optionally at least 5%, optionally at least 10%, optionally at least 20% and optionally at least 50% of the pitch between the beam paths in a direction across the beam paths. When the distance from the sample 208 to the detector array 240 is too low for a given pitch (or expressed otherwise the distance between the sample and the detector is insufficiently large relative to a given pitch for example of the beam grid or at least a beam and its neighbouring beams), then the detection efficiency may be undesirably reduced.

In an embodiment, the detector array 240 is configured such that adjacent (e.g. neighbouring) detector elements 405 detect the detection signals substantially simultaneously. In an embodiment all the detector elements of the detector array, for example the detector elements assigned to the different beams of the beam grid, detect respective detection signals substantially simultaneously. In an embodiment, the detection signals from the different detector elements are processed simultaneously, for example to derive a data set for respective detection signa. Such a data set may correspond to a pixel. Such data sets may be processed to derived a measurement. In an embodiment the pixels of the different beams are measured substantially simultaneously. In an embodiment, the detector elements 405 are configured to detect the signal electrons by integrating over a time period. In an embodiment, the induration time of adjacent detector elements 405 overlap at least a threshold percentage. The threshold percentage may be, for example, at least 50%, optionally at least 80%, optionally at least 90%, optionally at least 95%, optionally at least 98% and optionally at least 99%. Each of the pixels of the different beams is measured at the same moment in time, or at least over the same period of time, for example to provide a measurement at the same moment in time. An embodiment of the invention is expected to correct for cross talk regardless of the beam-to-beam position stability. That is the invention is intended to correct for cross talk independently of time. The invention may be achieved by applying the same correction to each beam for example accounting for its neighbouring beams. In an embodiment, the cross talk remover is configured to correct the detection signals per pixel.

In an embodiment, the cross talk remover is configured to correct the detection signals for cross talk of backscattered electrons. In general, backscattered electrons have a relatively high energy. As a result, the path of backscattered electrons emitted from the sample 208 are relatively unaffected by electromagnetic fields between the sample 208 and the detector array 240, for example a repulsion field applied between the sample and the proximate surface which in use faces the sample surface to filter secondary electrons out of the signal electrons that reach the detector array. As a result, the cross talk magnitude, i.e. the proportion of backscattered electrons that are detected by detector elements 405 other than the detector element 405 that corresponds to the portion from which the backscattered electrons are emitted, is not a function of local charging of the sample surface. The correction may be performed by operating on the detection signals independently of position of the sample 208 relative to the beam paths. This is because the cross talk magnitude is expected to be substantially constant. That is the net contribution to the detection signal derived from signal particles derived from neighbouring beams is substantially constant. That is the correction for the cross talk is substantially the same for all of the detection signals from the detector array.

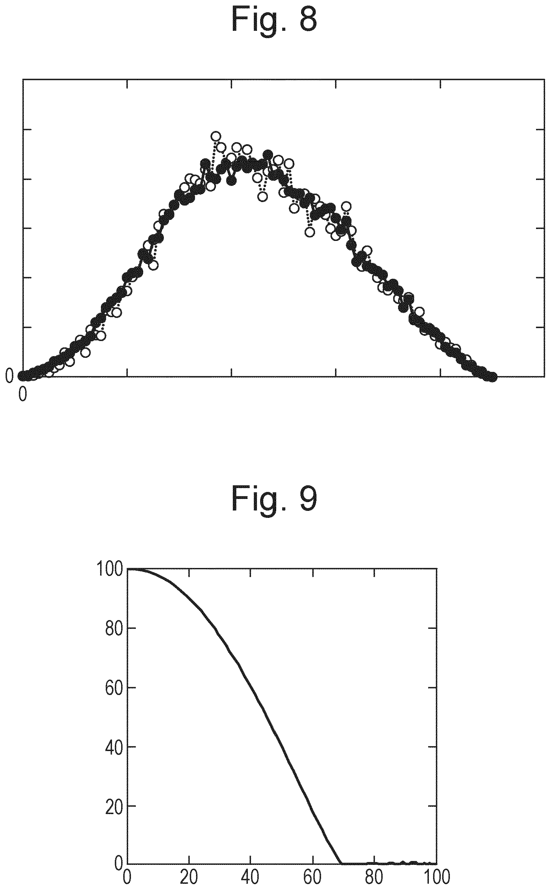

**FIG. 8** is a graph showing the relationship between the angle of backscattered electrons emitted from the sample surface and the number of backscattered electrons that are detected. **FIG. 8** shows the backscattered electron angle distribution. **FIG. 8** shows two plot lines. One plot line represents the backscattered electron angle distribution for backscattered electrons emitted from a silicon sample surface. The other plot line shows the backscattered electron angle distribution for backscattered electrons emitted from a tungsten sample surface.

As shown in **FIG. 8,** the backscattered electron angle distribution is substantially the same for the different types of material of the sample 208. The graph in **FIG. 8** shows two lines derived from two respective data sets from simulations. The two different data sets shown in the graph of **FIG. 8** were obtained using a different material comprised in the sample surface, for example silicon and tungsten. Silicon and tungsten have different electronic properties and are charged differently when irradiated with beams of electrons. If the cross talk magnitude were a function of local charging of the sample surface, then the backscattered electron angle distribution would be expected to be different for the different types of material. If the cross talk magnitude were a function of local charging of the sample surface, the backscattered electron angle distribution i.e. would be a function of material. The result of the simulation shown in **FIG. 8** indicates that the cross talk may be efficiently corrected for by operating on the detection signals independently of position of the sample 208 relative to the beam paths. The local charging of the sample surface does not need to be taken into account in order to correct for the cross talk. In an embodiment, the cross talk remover is configured to operate on the detection signals independently of a material composition of the sample 208.

The signal electrons emitted from the sample 208 may comprise backscattered electrons and secondary electrons. The proportion of the signal electrons that are backscattered electrons is greatly affected by the material composition of the sample 208. The graph in **FIG. 8** shows that surprisingly, the backscattered electron angle distribution is substantially unaffected by the material composition of the sample 208. An embodiment of the invention is expected to achieve surprisingly accurate removal of cross talk by operating on all detection signals independently of the scan position, for example of the respective beams of the beam grid.

In an embodiment, the detector elements 405 are configured to generate respective detection signals indicative of detected backscattered electrons. The cross talk remover is configured to correct the detections signals indicative of detected backscattered electrons by removing the cross talk of backscattered electrons.

In an embodiment, the detector elements 405 are configured to detect secondary electrons (as the signal electrons) so as to generate respective detection signals indicative of detected secondary electrons. In such an arrangement, the repulsion field applied between the electron-optical device and the sample may be reduced relative to an electron-optical apparatus intended to filter out secondary electrons from the signal particles reaching the detector elements, or the repulsion field is not present. The detection signals for the secondary electrons may include a proportion of the detection signal resulting from detected backscattered electrons. There may be cross talk of the backscattered electrons. In an embodiment, the cross talk remover is configured to correct the detection signals of secondary electrons for cross talk of backscattered electrons.

In an embodiment, there may be cross talk of secondary electrons. In other words, secondary electrons emitted from a portion may be detected by detector elements 405 other than the detector element 405 that corresponds to the portion from which the secondary electrons are emitted. In an embodiment, the cross talk remover is configured to correct detection signals for cross talk of secondary electrons. However, generally secondary electrons have a lower energy than backscattered electrons (for example 50eV or less) and their beam paths from the sample 208 are expected to be more greatly altered by electrostatic fields between the sample 208 and the detector 204. As a result, the cross talk magnitude for secondary electrons may vary as a function of local charging of the sample surface. Therefore, the cross talk of secondary electrons is expected to be removed less successfully when operating on the detection signals independently of the position of the sample 208 relative to the beam paths. However, an improvement in quality of detection signal may be observed.

In an embodiment, the electron-optical device 230 is operable in a backscattered electron detection mode. In an embodiment, the controller 50 is configured to control operation of the electron-optical device 230 in the backscattered electron detection mode. In an embodiment, the electric power source 290 is configured to apply potentials to the detector array 240 and/or the sample 208 in use, so as to control an electric field between the detector array 240 and the sample 208. For example, in an embodiment, the detector array 240 is configured to repel secondary electrons emitted from the sample 208 for example as described herein above. Such a backscattered electron detection mode may comprise operating the objective lens to accelerate the primary beams towards the sample, and optionally the control lens as a declaration lens so the primary beams have cross-over between the control lens array and the objective lens array. In an embodiment, the controller 50 is configured to control the electric power source 290 to apply a potential to the detector array 240 such that the detector array 240 repels secondary electrons from the sample 208. By repelling secondary electrons, the detector array 240 may be configured to detect backscattered electrons emitted from the sample 208 for example without a contribution to the detection signals derived from secondary electrons.

In an embodiment, the electron-optical device 230 is operable in a secondary electron detection mode. In the secondary electron detection mode, the secondary electrons may be accelerated by an electrostatic field between the sample 208 and the detector array 240. That is, as described herein above, the objective lens may decelerate the primary electrons towards the sample. Such a decelerating electric field for the primary beams may serve to function as an accelerating field for signal electrons emitted by the sample. For example, in an embodiment, the controller 50 is configured, when the electron-optical device is in operation, to control the electric power source 290 so as to apply potentials to the detector array 240 and/or the sample 208, so as to generate an electric field between the detector array 240 and the sample 208 that accelerates the secondary electrons towards the detector array 240. The repulsion field of the backscattered electron mode that is set between the sample and the facing surface of the electron-optical device 230 may be absent (i.e. not present).

In an embodiment, the cross talk remover is configured to deconvolve the detection signals so as to correct the detection signals for cross talk. In an embodiment, the cross talk remover is configured to perform a calculation in the data path so as to remove the cross talk. For example, the deconvolution may be performed by one or more mathematical operations.

Merely as an example to help demonstrate the application of the invention, in an embodiment, the cross talk remover is configured to operate on the detection signals using a matrix. Below is provided an example with 2% cross talk from each of the six neighbouring beams. The detection signals generated by the detector elements 405 are given by the equation below (equation 1):

Equation 1:

$$
\begin{pmatrix}
detecton\ signal\ at\ detector\ element\ 1 \\
detecton\ signal\ at\ detector\ element\ 2 \\
detecton\ signal\ at\ detector\ element\ 3 \\
... \\
... \\
detecton\ signal\ at\ detector\ element\ N
\end{pmatrix}
$$

$$
= A \cdot
\begin{pmatrix}
signal\ electrons\ emitted\ from\ portion\ 1 \\
signal\ electrons\ emitted\ from\ portion\ 2 \\
signal\ electrons\ emitted\ from\ portion\ 3 \\
... \\
... \\
signal\ electrons\ emitted\ from\ portion\ N
\end{pmatrix}
$$

where the detector array 240 comprises N detector elements and portion 1 is the portion of the surface of the sample 208 that corresponds to detector element 1, etc..

The matrix represents the percentage of cross talk from each of the neighbouring beams. In the example of the matrix shown (equation 2), the cross talk is taken to be zero beyond the six nearest neighbouring beams. That is there is a neighbour cut-off beyond the first order of neighbouring beams. However this limitation is selected for this example. The neighbour cut-off may be beyond any order of neighbouring beams as so desired.

Equation 2:

$A(12\%) =$

|    | 0  | 1  | 2  | 3  | 4  | 5  | 6  | 7  | 8  | 9   |
|----|----|----|----|----|----|----|----|----|----|-----|
| 0  | 88 | 2  | 2  | 2  | 0  | 0  | 0  | 0  | 0  | 0   |
| 1  | 2  | 88 | 2  | 2  | 2  | 0  | 0  | 0  | 0  | 0   |
| 2  | 2  | 2  | 88 | 2  | 2  | 2  | 0  | 0  | 0  | 0   |
| 3  | 2  | 2  | 2  | 88 | 2  | 2  | 2  | 0  | 0  | 0   |
| 4  | 0  | 2  | 2  | 2  | 88 | 2  | 2  | 2  | 0  | 0   |
| 5  | 0  | 0  | 2  | 2  | 2  | 88 | 2  | 2  | 2  | 0   |
| 6  | 0  | 0  | 0  | 2  | 2  | 2  | 88 | 2  | 2  | 2   |
| 7  | 0  | 0  | 0  | 0  | 2  | 2  | 2  | 88 | 2  | 2   |
| 8  | 0  | 0  | 0  | 0  | 0  | 2  | 2  | 2  | 88 | 2   |
| 9  | 0  | 0  | 0  | 0  | 0  | 0  | 2  | 2  | 2  | 88  |
| 10 | 0  | 0  | 0  | 0  | 0  | 0  | 0  | 2  | 2  | 2   |
| 11 | 0  | 0  | 0  | 0  | 0  | 0  | 0  | 0  | 2  | 2   |
| 12 | 0  | 0  | 0  | 0  | 0  | 0  | 0  | 0  | 0  | 2   |
| 13 | 0  | 0  | 0  | 0  | 0  | 0  | 0  | 0  | 0  | 0   |
| 14 | 0  | 0  | 0  | 0  | 0  | 0  | 0  | 0  | 0  | 0   |
| 15 | 0  | 0  | 0  | 0  | 0  | 0  | 0  | 0  | 0  | ... |

%

In an embodiment, the cross talk remover is configured to operate on the detections signals using an inverse of a matrix comprising cross talk values. The cross talk values are indicative of proportions of each detection signals resulting from the detector element 405 detecting signal electrons emitted from portions other than its respective portion. In the matrix shown, the cross talk values are 2% for each of the six first order neighbouring beams and zero for other beams. In an embodiment, the detection signals can be corrected by multiplying the measured detection signals by the inverse matrix shown below.

Equation 3:

$A(12\%)^{-1} =$

|    | 0 | 1 | 2 | 3 | 4 |
|----|---|---|---|---|---|
| 0  | 113.968 | -2.373 | -2.432 | -2.488 | 0.162 |
| 1  | -2.373 | 113.968 | -2.373 | -2.432 | -2.488 |
| 2  | -2.432 | -2.373 | 113.968 | -2.373 | -2.432 |
| 3  | -2.488 | -2.432 | -2.373 | 113.968 | -2.373 |
| 4  | 0.162 | -2.488 | -2.432 | -2.373 | 113.968 |
| 5  | 0.107 | 0.162 | -2.488 | -2.432 | -2.373 |
| 6  | 0.051 | 0.107 | 0.162 | -2.488 | -2.432 |
| 7  | $-7.185 \cdot 10^{-3}$ | 0.051 | 0.107 | 0.162 | -2.488 |
| 8  | $-3.413 \cdot 10^{-3}$ | $-7.185 \cdot 10^{-3}$ | 0.051 | 0.107 | 0.162 |
| 9  | $-9.194 \cdot 10^{-4}$ | $-3.413 \cdot 10^{-3}$ | $-7.185 \cdot 10^{-3}$ | 0.051 | 0.107 |
| 10 | $2.595 \cdot 10^{-4}$ | $-9.194 \cdot 10^{-4}$ | $-3.413 \cdot 10^{-3}$ | $-7.185 \cdot 10^{-3}$ | 0.051 |
| 11 | $9.25 \cdot 10^{-5}$ | $2.595 \cdot 10^{-4}$ | $-9.194 \cdot 10^{-4}$ | $-3.413 \cdot 10^{-3}$ | $-7.185 \cdot 10^{-3}$ |
| 12 | $1.313 \cdot 10^{-5}$ | $9.25 \cdot 10^{-5}$ | $2.595 \cdot 10^{-4}$ | $-9.194 \cdot 10^{-4}$ | $-3.413 \cdot 10^{-3}$ |
| 13 | $-8.253 \cdot 10^{-6}$ | $1.313 \cdot 10^{-5}$ | $9.25 \cdot 10^{-5}$ | $2.595 \cdot 10^{-4}$ | $-9.194 \cdot 10^{-4}$ |
| 14 | $-2.218 \cdot 10^{-6}$ | $-8.253 \cdot 10^{-6}$ | $1.313 \cdot 10^{-5}$ | $9.25 \cdot 10^{-5}$ | $2.595 \cdot 10^{-4}$ |
| 15 | $-6.69 \cdot 10^{-8}$ | $-2.218 \cdot 10^{-6}$ | $-8.253 \cdot 10^{-6}$ | $1.313 \cdot 10^{-5}$ | ... |

%

In an embodiment, the cross talk remover is configured to operate on the detection signals using cross talk values. In an embodiment, the cross talk values are comprised in a matrix. Alternatively, the cross talk remover may be configured to operate on the detection signals without using a matrix, for example, by performing a mathematical operation using weighting factors for different detection signals, the weighting factors related to the cross talk values. For example, in an embodiment, the cross talk remover is configured to add the detection signals from neighbouring beams to the detection signal of a given beam with certain weighting factors related to the cross talk values.

In an embodiment, the cross talk values are constant for a plurality of positions of the sample 208 relative to the beam paths. For example, the cross talk values may be independent of the position of the sample 208 relative to the beam path. The cross talk value may be constant for all of the positions of the sample 208 relative to the beam paths. The cross talk values may be constant throughout a scan. The cross talk values may be substantially the same for example for the different detection signals or pixels derived from the different detector elements of a detector, and/or from the impact with the sample of the different primary beams of the beam grid.

FIG. 9 is a graph showing the relationship between the cross talk in a detection signal and the SNR as a percentage of the SNR where there is no cross talk. The SNR may be the ratio of the signal content to the noise content of the signal, for example as the relative magnitudes of the signal and noise components in the detection signal. Typically, the signal component of the detection signal has a greater magnitude than the noise component, for example the signal component may be five times or more larger in magnitude than the standard deviation of the noise. As shown in FIG. 9, the operation of the cross talk remover generally reduces the SNR compared to the situation where cross talk is absent. Application of the invention is beneficial for such systems with a high SNR. Cross talk is absent where the pitch is made very large such that cross talk is absent.

FIG. 9 shows the net effect on SNR. The SNR is improved by the operation of the cross talk remover because the detection of additional signal electrons from neighbouring channel are added, which increases the effective detection efficiency of the detector array 240. However, the noise from neighbouring channels is also added which tends to reduce the SNR. The net result is a general reduction in SNR, as shown in FIG. 9.

Although the SNR is in general reduced by the deconvolution (i.e. the removal of the cross talk), the SNR remains surprisingly high, particularly for relatively lower cross talk magnitudes. An embodiment of the invention is expected to achieve surprisingly accurate removal of cross talk by operating on all detection signals independently of the scan position.

Although the SNR generally is reduced, the additional noise originating from the neighbouring channels can be reduced by using a higher dose. The dose relates to the number of electrons that are directed onto the sample 208, i.e. the number of electrons per unit area. For example, a higher current of the beams 211, 212, 213 may be used. The beams may be scanned on each portion for a longer time, in order to improve the SNR. That is the dose is the beam current over the time for scanning a portion of the sample 208 (e.g. pixel). A higher dose means more electrons per unit area. The dose is a result of the beam current, pixel size and the time per pixel (dwell time). The time per pixel can be changed by doing averaging. In contrast, when the cross talk remover is not used to correct the detection signals, then the SNR cannot be reduced by using a higher dose because it is structural noise, also called interference. When the noise is random (such as due to shot noise, which may be the dominant noise source), the SNR can be improved by increasing the dose (e.g. using more averages and/or smaller pixel size). However, the effect of cross talk cannot be removed by doing this. By removing the cross talk using the cross talk remover, the noise may increase, but the noise can be reduced by increasing the dose (e.g. using more averages and/or smaller pixel size).

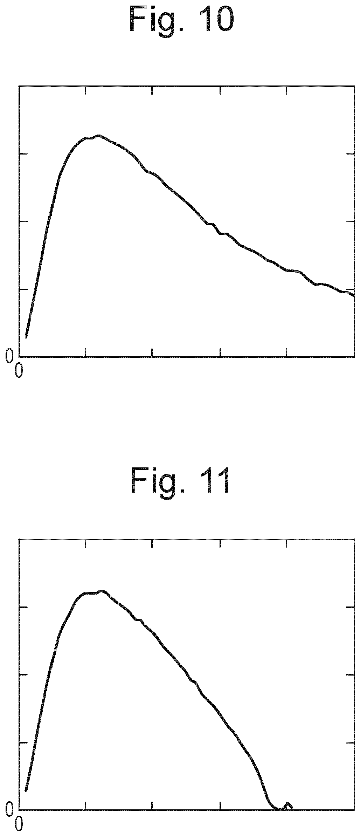

FIG. 10 is a graph showing the relationship between the distance from the sample 208 to the detector array 240 and the effective detection efficiency, an example with a pitch between beams in the beam grid selected from the range of 20 to 200 μm and a distance with a maximum in the range of 20 to 200 μm between the sample and detector array. FIG. 10 shows the relationship when the cross talk remover is not used. FIG. 11 shows the same relationship for a situation having the same parameters when the cross talk remover is used to remove the cross talk. As shown from a comparison between FIG. 10 and FIG. 11, the deconvolution of the detection signals generally reduces the effective detection efficiency. The effective detection efficiency is reduced as a result of the generally reduced SNR. However, the effective detection efficiency may be increased by using a higher dose (more averages). More specifically, the reduction of the effective detection efficiency can be counteracted by using a higher dose (e.g. higher beam current, smaller pixel size and/or greater dwell time which can be achieved by doing more averages).

Arrangements of the present disclosure may be embodied as methods.

It is noted that references to having an electric field associated with an element means applying potentials between that an element and another element of the electron-optical device or sample to generate such a field. Reference to the application of applying potentials to an electron-optical element such as a sample, detector array or a lens array such as the control lens array or the objective lens array, is intended to mean control of the electron source to apply appropriate potentials to the referenced electron-optical elements and/or sample, (noting that in this instance an electron-optical element is intended to include detector array).

The descriptions above are intended to be illustrative, not limiting. Thus, it will be apparent to one skilled in the art that modifications may be made as described without departing from the scope of the claims and clauses set out below.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses appended hereto.

There is provided the following clauses:

Clause 1. A charged particle-optical apparatus configured to direct charged particles toward a sample, the charged particle-optical apparatus comprising: a charged particle-optical device configured to direct a plurality of beams of charged particles along respective beam paths toward a sample; a support configured to support the sample and configured to position the sample relative to the beam paths; a detector array of detector elements configured to detect signal charged particles emitted from respective areas of a surface of the sample so as to generate respective detection signals; and a cross talk remover configured to correct the detection signals for cross talk by operating on the detection signals independently of position of the sample relative to the beam paths.

Clause 2. The charged particle-optical apparatus of clause 1, wherein the detector array is proximate the sample.

Clause 3. The charged particle-optical apparatus of clause 1 or 2, wherein the detector array is positioned to face the sample.

Clause 4. The charged particle-optical apparatus of any preceding clause, wherein the detector array provides an end surface of the charged particle-optical device.

Clause 5. The charged particle-optical apparatus of any preceding clause, wherein a distance between the detector array and the sample in a direction along the beam paths is at most 100%, optionally at most 50%, optionally at most one 20% and optionally at most 10%, of a pitch between the beam paths in a direction across the beam paths.

Clause 6. The charged particle-optical apparatus of any preceding clause, wherein a distance between the detector array and the sample in a direction along the beam paths is at least 2%, optionally at least 5% and optionally at least 10%, of a pitch between the beam paths in a direction across the beam paths.

Clause 7. The charged particle-optical apparatus of any preceding clause, wherein the detector array is configured such that adjacent detector elements detect the detection signals substantially simultaneously.

Clause 8. The charged particle-optical apparatus of any preceding clause, wherein the cross talk remover is configured to deconvolve the detection signals so as to correct the detection signals for cross talk.

Clause 9. The charged particle-optical apparatus of any preceding clause, wherein the cross talk remover is configured to operate on the detection signals using a matrix.

Clause 10. The charged particle-optical apparatus of any preceding clause, wherein the cross talk remover is configured to operate on the detection signals using cross talk values indicative of proportions of each detection signal resulting from the detector element detecting signal charged particles emitted from areas other than its respective area.

Clause 11. The charged particle-optical apparatus of clause 10, wherein the cross talk values are constant for a plurality of positions of the sample relative to the beam paths.

Clause 12. The charged particle-optical apparatus of clause 10 or 11, wherein the cross talk values are independent of position of the sample relative to the beam paths.

Clause 13. The charged particle-optical apparatus of any preceding clause, wherein the cross talk remover is configured to operate on the detection signals using an inverse of a matrix comprising the cross talk values.

Clause 14. The charged particle-optical apparatus of any preceding clause, wherein the cross talk remover comprises a processor comprising instructions for instructing the processor to correct the detection signals for cross talk.

Clause 15. The charged particle-optical apparatus of any preceding clause, wherein the cross talk remover comprises electronics configured to correct the detection signals for cross talk.

Clause 16. The charged particle-optical apparatus of any preceding clause, wherein the charged particle-optical device comprises the detector array.

Clause 17. The charged particle-optical apparatus of any preceding clause, wherein the charged particle-optical device comprises an objective lens array configured to focus he beams onto the sample.

Clause 18. The charged particle-optical apparatus of clause 17, wherein the objective lens array comprises a plurality of objective lenses for respective detector elements.

Clause 19. The charged particle-optical apparatus of clause 17 or 18, wherein the objective lens array comprises a plurality of plates in which apertures are defined for the beam paths.

Clause 20. The charged particle optical apparatus of any of clauses 17-19, wherein the objective lens array comprises the detector array.

Clause 21. The charged particle optical apparatus of any of clauses 17-20, wherein the detector array is located between the objective lens array and the sample.

Clause 22. The charged particle-optical apparatus of any preceding clause, wherein the detector array is configured to repel secondary charged particles emitted from the sample.

Clause 23. The charged particle-optical apparatus of any preceding clause, comprising: an electric power source configured to apply potentials to one or more electrodes of the charged particle-optical device.

Clause 24. The charged particle-optical apparatus of clause 23, wherein the electric power source is configured to apply potentials to the detector array and/or the sample in use, so as to control an electric field between the detector array and the sample.

Clause 25. The charged particle-optical apparatus of any preceding clause, wherein the signal charged particles comprise backscattered charged particles and the corrected signals represent backscattered charged particles.

Clause 26. The charged particle-optical apparatus of any preceding clause, wherein the signal charged particles comprise secondary charged particles and the corrected signals represent secondary charged particles.

Clause 27. The charged particle-optical apparatus of any preceding clause, wherein the cross talk remover is configured to operate on the detection signals independently of a material composition of the sample.

Clause 28. The charged particle-optical apparatus of any preceding clause, wherein the cross talk remover is configured to correct the detection signals for respective pixels of an image of the sample.

Clause 29. The charged particle-optical apparatus of clause 28, wherein the pixels of the different beams are measured simultaneously.

Clause 30. The charged particle-optical apparatus of clause 29, wherein simultaneously comprises overlapping integration time above a threshold.

Clause 31. The charged particle-optical apparatus of clause 29, wherein the threshold is at least 50 percent, at least 80 percent, at least 90 percent, or at least 95 percent.

Clause 32. The charged particle-optical apparatus of any preceding clause, wherein the detector elements corresponding to the other areas from which signal charged particles may be detected comprise neighbouring detector elements of a respective detector element.

Clause 33. The charged particle-optical apparatus of clause 32, wherein the neighbouring detector elements comprise at least nearest neighbours, at least second, third, and/or fourth order neighbouring detector elements.

Clause 34. The charged particle-optical apparatus of any preceding clause, wherein at least some of the detector elements are arranged in a two dimension array.

Clause 35. The charged particle-optical apparatus of clause 34, wherein each detector element in the detector array has a number of neighbouring detector elements.

Clause 36. A method for detecting backscattered charged particles, the method comprising: directing a plurality of beams of charged particles along respective beam paths toward a sample; supporting the sample and positioning the sample relative to the beam paths; detecting signal charged particles emitted from respective areas of a surface of the sample with respective detector elements of a detector array so as to generate respective detection signals; and correcting the detection signals for cross talk by operating on the detection signals independently of position of the sample relative to the beam paths.

Clause 37. The method of clause 36, wherein the detector array is proximate the sample.

Clause 38. The method of clause 36 or 37, wherein the detector array is positioned to face the sample.

Clause 39. The method of any of clauses 36-38, wherein a distance between the detector array and the sample in a direction along the beam paths is at most 100%, optionally at most 50%, optionally at most one 20% and optionally at most 10%, of a pitch between the beam paths in a direction across the beam paths.

Clause 40. The method of any of clauses 36-39, wherein a distance between the detector array and the sample in a direction along the beam paths is at least 2%, optionally at least 5% and optionally at least 10%, of a pitch between the beam paths in a direction across the beam paths.

Clause 41. The method of any of clauses 36-40, wherein the detector array is configured such that adjacent detector elements detect the detection signals substantially simultaneously.

Clause 42. The method of any of clauses 36-38, comprising deconvolving the detection signals so as to correct the detection signals for cross talk.

Clause 43. The method of any of clauses 36-42, comprising operating on the detection signals using a matrix.

Clause 44. The method of any of clauses 36-43, comprising operating on the detection signals using cross talk values indicative of proportions of each detection signal resulting from the detector element detecting signal charged particles emitted from areas other than its respective area.

Clause 45. The method of clause 44, wherein the cross talk values are constant for a plurality of positions of the sample relative to the beam paths.

Clause 46. The method of clause 44 or 45, wherein the cross talk values are independent of position of the sample relative to the beam paths.

Clause 47. The method of any of clauses 36-46, comprising operating on the detection signals using an inverse of a matrix comprising the cross talk values.

Clause 48. The method of any of clauses 36-47, a processor comprising instructions for instructing the processor corrects the detection signals for cross talk.

Clause 49. The method of any of clauses 36-48, wherein electronics correct the detection signals for cross talk.

Clause 50. The method of any of clauses 36-49, comprising the detector array repelling secondary charged particles emitted from the sample.

Clause 51. The method of any of clauses 36-50, comprising applying potentials to one or more electrodes of the charged particle-optical device.

Clause 52. The method of clause 51, comprising applying potentials to the detector array and/or the sample in use, so as to control an electric field between the detector array and the sample.

Clause 53. The method of any of clauses 36-52, wherein the signal charged particles comprise backscattered charged particles and the corrected signals represent backscattered charged particles.

Clause 54. The method of any of clauses 36-53, wherein the signal charged particles comprise secondary charged particles and the corrected signals represent secondary charged particles.

Clause 55. The method of any of clauses 36-54, comprising operating on the detection signals independently of a material composition of the sample.

Clause 56. The method of any of clauses 36-55, comprising correcting the detection signals for respective pixels of an image of the sample.

Clause 57. The method of clause 56, wherein the pixels of the different beams are measured simultaneously.

Clause 58. The method of clause 57, wherein simultaneously comprises overlapping integration time above a threshold.

Clause 59. The method of clause 58, wherein the threshold is at least 50 percent, at least 80 percent, at least 90 percent, or at least 95 percent.

Clause 60. The method of any of clauses 36-59, wherein the detector elements corresponding to the other areas from which signal charged particles may be detected comprise neighbouring detector elements of a respective detector element.

Clause 61. The method of clause 60, wherein the neighbouring detector elements comprise at least nearest neighbours, at least second, third, and/or fourth order neighbouring detector elements.

Clause 62. The method of any of clauses 36-61, wherein at least some of the detector elements are arranged in a two dimension array.

Clause 63. The method of clause 62, wherein each detector element in the detector array has a number of neighbouring detector elements.

Clause 64. A charged particle-optical apparatus configured to direct charged particles toward a sample location, the charged particle-optical apparatus comprising: a charged particle-optical device configured to direct a plurality of beams of charged particles along respective beam paths toward a sample; a support configured to support the sample and configured to position the sample relative to the beam paths; a detector array of detector elements configured to detect signal charged particles emitted from respective areas of a surface of the sample so as to generate respective detection signals; and a cross talk remover configured to correct the detection signals for cross talk by operating on the detection signals to generate corrected values: when operating the detection signal applying a correction (e.g. cross talk value) that is the same for different relative positions between the support and the beams; and/or independently of relative position between the sample and the beams.

Clause 65. A method for detecting signal charged particles from a sample, the method comprising: directing a plurality of beams of charged particles along respective beam paths toward a sample supported by a sample support; detecting signal charged particles from respective portions of a sample surface as respective detection signals using respective detector elements of a detector array correcting the detection signals for cross talk by operating on the detection signals to generate corrected values: by applying a correction(e.g. cross talk value) that is the same for different relative positions of the support and the beams; and/or independently of the relative position between the sample and the beams.

**Claims**

1. A charged particle-optical apparatus configured to direct charged particles toward a sample, the charged particle-optical apparatus comprising:

   a charged particle-optical device configured to direct a plurality of beams of charged particles along respective beam paths toward a sample;
   a support configured to support the sample and configured to position the sample relative to the beam paths;
   a detector array of detector elements configured to detect signal charged particles emitted from respective areas of a surface of the sample so as to generate respective detection signals; and
   a cross talk remover configured to correct the detection signals for cross talk by operating on the detection signals independently of position of the sample relative to the beam paths.

**2.** The charged particle-optical apparatus of claim 1, wherein the detector array is proximate the sample.

**3.** The charged particle-optical apparatus of claim 1 or 2, wherein the detector array is positioned to face the sample.

**4.** The charged particle-optical apparatus of any preceding claim, wherein a distance between the detector array and the sample in a direction along the beam paths is at most 100%, optionally at most 50%, optionally at most one 20% and optionally at most 10%, of a pitch between the beam paths in a direction across the beam paths and/or wherein a distance between the detector array and the sample in a direction along the beam paths is at least 2%, optionally at least 5% and optionally at least 10%, of a pitch between the beam paths in a direction across the beam paths.

**5.** The charged particle-optical apparatus of any preceding claim, wherein the detector array is configured such that adjacent detector elements detect the detection signals substantially simultaneously.

**6.** The charged particle-optical apparatus of any preceding claim, wherein the cross talk remover is configured to deconvolve the detection signals so as to correct the detection signals for cross talk.

**7.** The charged particle-optical apparatus of any preceding claim, wherein the cross talk remover is configured to operate on the detection signals using a matrix.

**8.** The charged particle-optical apparatus of any preceding claim, wherein the cross talk remover is configured to operate on the detection signals using cross talk values indicative of proportions of each detection signal resulting from the detector element detecting signal charged particles emitted from areas other than its respective area.

**9.** The charged particle-optical apparatus of claim 8, wherein the cross talk values are constant for a plurality of positions of the sample relative to the beam paths.

**10.** The charged particle-optical apparatus of claim 8 or 9, wherein the cross talk values are independent of position of the sample relative to the beam paths.

**11.** The charged particle-optical apparatus of any preceding claim, wherein the charged particle-optical device comprises an objective lens array configured to focus the beams onto the sample, desirably the objective lens array is configured to accelerate plurality of beams towards the sample.

**12.** The charged particle-optical apparatus of claim 11, wherein the objective lens array comprises a plurality of objective lenses for respective detector elements.

**13.** The charged particle-optical apparatus of any preceding claim, wherein the detector array is configured to repel secondary charged particles emitted from the sample.

**14.** The charged particle-optical apparatus of any preceding claim, wherein the signal charged particles comprise backscattered charged particles and the corrected signals represent backscattered charged particles.

**15.** The charged particle-optical apparatus of any preceding claim, wherein the cross talk remover is configured to operate on the detection signals independently of a material composition of the sample.

# Fig. 1

Fig. 2

# Fig. 3

# Fig. 4

**Fig. 5**

**Fig. 6**

**Fig. 7**

# Fig. 8

# Fig. 9

# Fig. 10

# Fig. 11

| | Europäisches Patentamt European Patent Office Office européen des brevets | **EUROPEAN SEARCH REPORT** | Application Number EP 23 20 6125 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/301811 A1 (FANG WEI [US] ET AL) 22 September 2022 (2022-09-22) | 1-12,14, 15 | INV. H01J37/22 H01J37/244 H01J37/28 |
| Y | * abstract * * paragraph [0001] – paragraph [0190] * * figures 1, 2 * | 13 | |
| A,D | EP 4 156 227 A1 (ASML NETHERLANDS BV [NL]) 29 March 2023 (2023-03-29) * abstract * * paragraph [0001] – paragraph [0237] * * figures 4, 7-8 * | 3,11,12 | |
| Y | WO 2020/146129 A1 (APPLIED MATERIALS ISRAEL LTD [IL]; APPLIED MATERIALS INC [US]) 16 July 2020 (2020-07-16) * abstract * * paragraph [0001] – paragraph [0078] * | 13 | |

**TECHNICAL FIELDS SEARCHED (IPC)**

H01J

The present search report has been drawn up for all claims

| Place of search | Date of completion of the search | Examiner |
|---|---|---|
| Munich | 19 March 2024 | Bridi, Dorian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

**EP 23 20 6125**

This annex lists the patent family members relating to the patent documents cited in the above-mentioned European search report.
The members are as contained in the European Patent Office EDP file on
The European Patent Office is in no way liable for these particulars which are merely given for the purpose of information.

**19-03-2024**

| Patent document cited in search report | | | Publication date | Patent family member(s) | | Publication date |
|---|---|---|---|---|---|---|
| US 2022301811 | A1 | | 22-09-2022 | CN | 114556515 A | 27-05-2022 |
| | | | | KR | 20220032615 A | 15-03-2022 |
| | | | | TW | 202113349 A | 01-04-2021 |
| | | | | TW | 202223375 A | 16-06-2022 |
| | | | | US | 2022301811 A1 | 22-09-2022 |
| | | | | WO | 2021028366 A1 | 18-02-2021 |
| EP 4156227 | A1 | | 29-03-2023 | EP | 4156227 A1 | 29-03-2023 |
| | | | | TW | 202328812 A | 16-07-2023 |
| | | | | WO | 2023046440 A1 | 30-03-2023 |
| WO 2020146129 | A1 | | 16-07-2020 | CN | 113614875 A | 05-11-2021 |
| | | | | EP | 3909066 A1 | 17-11-2021 |
| | | | | JP | 2022516668 A | 01-03-2022 |
| | | | | KR | 20210102988 A | 20-08-2021 |
| | | | | TW | 202034369 A | 16-09-2020 |
| | | | | US | 2021335569 A1 | 28-10-2021 |
| | | | | WO | 2020146129 A1 | 16-07-2020 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2021156121 A1
- EP 3971940 A1
- EP 3971939 A1
- EP 21199203